# EUROPEAN PATENT APPLICATION

(11) **EP 2 416 365 A1**
(43) Date of publication of application: **08.02.2012**
(21) Application number: 10758297.5
(22) Date of filing: 01.04.2010
(51) Int. Cl.: H01L 29/78, H01L 21/205, H01L 21/336, H01L 21/8238, H01L 27/092, H01L 29/161, H01L 51/05, H01L 51/30, H01L 51/40

(54) **FIELD-EFFECT TRANSISTOR**

(30) Priority: 01.04.2009 JP 2009089353
(71) Applicant: National University Corporation Hokkaido University, Sapporo-shi, Hokkaido 060-0808 (JP); Tohoku University, Aoba-ku Sendai-shi Miyagi 980-8577 (JP)
(72) Inventor: SANO, Eiichi, Sapporo-shi, Hokkaido 060-8628 (JP); OTSUJI, Taiichi, Miyagi 980-0812 (JP)
(74) Representative: Schwabe - Sandmair - Marx
(86) International application number: PCT/JP2010/002412
(87) International publication number: WO 2010/113518

(57) **Abstract**

The disclosed field-effect transistor has a graphene channel, and does not exhibit ambipolar properties. Specifically, the field-effect transistor has a semi-conducting substrate; a channel including a graphene layer disposed on the aforementioned semiconductor substrate; a source electrode and drain electrode comprising a metal; and a gate electrode. The aforementioned channel and the aforementioned source and drain electrodes comprising a metal are connected via a semiconductor layer.

## Description

### Technical Field

The present invention relates to a field-effect transistor, and more specifically to a field-effect transistor having a graphene channel.

### Background Art

The field-effect transistor has a channel made of a semiconductor, a source electrode and a drain electrode that are in contact with the channel, and a gate electrode that controls the electric current flowing through the channel. Further, a field-effect transistor in which the channel is made of graphene is also proposed (See, for example, Patent Literature 1).

Graphene is generally a monolayer sheet having a six-membered ring structure made of carbon atoms. Since graphene is outstandingly excellent in electron transportation properties as compared with any of the already existing semiconductors, a field-effect transistor having a channel made of graphene is expected to be capable of outstandingly improving the speed performance of a transistor that faces a miniaturization limit. However, ideal graphene has a band structure in which the conduction band and the valence electron band are in contact at one point, and does not have a band gap. For this reason, studies related to a method of realizing a band gap are eagerly carried out (Non-Patent Literatures 1 to 3).

First means (nanoribbon), in which the channel width in a vertical direction with respect to the electric current is restricted to a nanometer size, can exhibit the band gap by electron confinement in the width direction (See Non-Patent Literature 1).

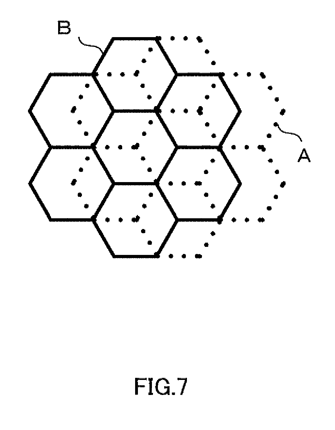

Second means (symmetry breaking) that realizes a band gap exhibits a band gap by breaking the symmetry of A and B sites of a graphene layer caused by substrate atom arrangement in a lower part of the graphene layer (See Non-Patent Literature 2). Among the graphene fabricated on SiC, the π electrons of the first layer graphene are shared by SiC and do not contribute to electric conduction (For this reason, the first layer graphene is referred to as a buffer layer). On the other hand, the π electrons of the graphene on the buffer layer contribute to electric conduction. Here, when the six-membered ring of the buffer layer and the six-membered ring of the graphene layer are laminated in a complete overlap, the symmetry between the unit lattices (A site and B site) within the six-membered rings is maintained. However, in an A-B lamination such as in FIG.7, the symmetry between the A site and the B site of the graphene layer is broken, thereby generating a difference in the potential energies of the A site and the B site. For this reason, a band gap (real measured value is about 0.2 eV) is generated corresponding to this difference.

Third means (bilayer graphene) that realizes a band gap exhibits the band gap by providing a potential difference between the layers of the bilayer graphene. Specifically, as shown in FIG.7, the graphene layers are subjected to A-B lamination, and a band gap is generated by providing a potential difference between the two layers. A band gap value can be theoretically deduced by determining an eigen value. As a method of providing a potential difference, impurity doping or electric field application from the outside is considered.

However, the above-described means each have the following problems. A nanoribbon does not have a band gap when the number of carbon atoms of the channel width in the vertical direction relative to the electric current is 3m+2 (m: natural number). For this reason, the channel width must be adjusted in an atomic order of several nanometers or less, and this is difficult by the current processing technique.

By this breaking symmetry, there a view stating that the band gap is exhibited by the breaking of symmetry on the SiC substrate and a view denying that, and these are in the midst of dispute, so that the details thereof are not clear.

In the case of bilayer graphene by impurity doping, even if each graphene layer is doped with donors and acceptors at a surface density of 10¹³cm⁻², the obtained band gap is about 0.2 eV (calculation is made by a method of solving the tight-binding Hamiltonian and Poisson equation in a self-consistent manner). Also, in the case of bilayer graphene by outside electric field application, a double gate structure having a gate in the upper and lower parts is needed, and the fabrication is extremely difficult.

### Citation List

### Patent Literature

### [PTL1]

International Publication No. 2008/108383 Pamphlet

### Non-patent Literatures

### [NPTL1]

Y. W. Son et al., "Energy gaps in graphene nanoribbons," Phys. Rev. Lett., vol. 97, p. 216803, 2006.

### [NPTL2]

S. Y. Zhou et al., "Substrate-induced bandgap opening in epitaxial graphene," Nature Mater., vol. 6, pp. 770-775, 2007.

### [NPTL3]

E. McCann, "Asymmetry gap in the electronic band structure of bilayer graphene," Phys. Rev. B, vol. 74, p. 161403(R), 2006.

### Summary of Invention

### Technical Problem

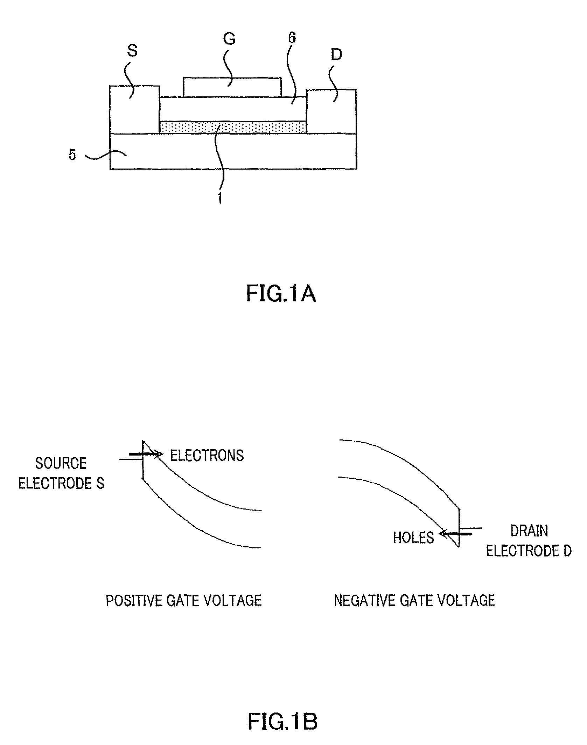

FIG.1A shows a cross-sectional view of an example of a graphene channel field-effect transistor (GFET) having a generally conceivable structure. Referring to FIG.1A, it has silicon carbide substrate 5, source electrode S, drain electrode D, gate electrode G, graphene layer 1 as a channel, and gate insulating layer 6. Source electrode S and drain electrode D made of a metal are directly in source contact and drain contact with the graphene channel.

The operation mechanism of a field-effect transistor having a source electrode and a drain electrode made of metal is different from the operation mechanism of a typical silicon MOSFET. The field-effect transistor shown in FIG.1A operates by controlling the Schottky barrier between the source or drain and the channel, and for this reason, is referred to also as a "Schottky barrier field-effect transistor".

In the Schottky barrier field-effect transistor, when the band gap of the channel semiconductor thereof is small, the electrons injected from the source contribute to conduction when a positive voltage is applied between the source and the gate; and the holes injected from the drain contribute to conduction when a negative voltage is applied between the source and the gate. This is referred to as ambipolar properties.

FIG.1B shows a schematic view of potential distribution between the source and the channel and between the drain and the channel when a voltage is applied between the source and the gate of the field-effect transistor shown in FIG.1A. The left side of FIG.1B shows a potential distribution when a positive voltage is applied between the source and the gate; and the right side of FIG.1B shows a potential distribution when a negative voltage is applied between the source and the gate. As shown in FIG.1B, when a positive gate voltage is applied, electrons are injected from the source and travel through the channel to flow into the drain, whereby an electron current flows. On the other hand, when a negative gate voltage is applied, holes are injected from the drain and travel through the channel to flow into the source, whereby a hole current flows. In this manner, the ambipolar properties are exhibited.

As described above, the band gap of graphene will inevitably have a small value of about 0.2 eV by using any of the conventional methods. Therefore, in a field-effect transistor having a channel made of graphene, when source contact and drain contact to the channel are provided by metal electrodes as shown in FIG.1A, it is expected that the so-called ambipolar properties appear in which an electron current flows when a positive voltage is applied between the source and the gate; and a hole current flows when a negative voltage is applied between the source and the gate.

A field-effect transistor having ambipolar properties is a property unsuitable for realizing a complementary logic circuit that is often used in a silicon MOSFET. However, a graphene channel field-effect transistor for evading the ambipolar properties has not been proposed so far.

Therefore, an object of the present invention is to provide a field-effect transistor having a graphene channel and not exhibiting the ambipolar properties.

### Solution to Problem

Namely, the present invention relates to a field-effect transistor and others shown below.

[1] A field-effect transistor having a semiconductor substrate, a channel including a graphene layer disposed on said semiconductor substrate, a source electrode and a drain electrode comprising a metal, and a gate electrode, wherein
said channel and said source and drain electrodes comprising a metal are connected via a semiconductor layer.
[2] The field-effect transistor according to [1], wherein said semiconductor layer is a source region and a drain region of said semiconductor substrate.

[3] The field-effect transistor according to [1] or [2], wherein
said graphene layer is formed on a layer comprising a graphene precursor disposed on said semiconductor substrate, and
said channel and said source and drain electrodes comprising a metal are connected via said semiconductor layer and said layer comprising a graphene precursor.
[4] The field-effect transistor according to [1] or [2], wherein
said graphene layer is formed on a silicon carbide layer disposed on said semiconductor substrate, and
said channel and said source and drain electrodes comprising a metal are connected via said semiconductor layer and said silicon carbide layer.
[5] The field-effect transistor according to [4], wherein
said silicon carbide layer has a thickness of 100 nm or less.

[6] The field-effect transistor according to any one of [1] to [5], which is an n-type field-effect transistor wherein
a source region and a drain region of said graphene layer are n-type doped, and
the semiconductor layer that connects said channel and said source and drain electrodes comprising a metal is n-type doped.
[7] The field-effect transistor according to any one of [1] to [5], which is a p-type field-effect transistor wherein
a source region and a drain region of said graphene layer are p-type doped, and
the semiconductor layer that connects said channel and said source and drain electrodes comprising a metal is p-type doped.

[8] The field-effect transistor according to any one of [1] to [7], wherein
said graphene layer is a graphene layer including two or more layers, and
a potential difference can be given between the layers of said graphene layer.
[9] The field-effect transistor according to [8], wherein said graphene layer is made of two layers. [10] The field-effect transistor according to [8], wherein the potential difference is given between the layers of said graphene layer by applying a built-in electric field between said semiconductor substrate and the channel or by applying a bias to the semiconductor substrate.

[11] A complementary logic circuit comprising a field effect transistor according to said [6] and a field effect transistor according to said [7].

### Advantageous Effects of Invention

The field-effect transistor of the present invention can realize a super low electric power consumption and super large scale integration that a conventional CMOS circuit has while enjoying super high-speed properties that a graphene material has.

### Brief Description of the Drawings

FIG.1A shows an example of a field-effect transistor having a graphene channel; and FIG.1B shows a schematic potential distribution of the field-effect transistor shown in FIG.1A;
FIG.2A is a schematic cross-sectional view of a field-effect transistor (n-type) of the present invention; and FIG.2B is a schematic cross-sectional view of a field-effect transistor (p-type) of the present invention.
FIG.3A shows a schematic potential distribution along a conduction path from the source electrode to the channel of the field-effect transistor shown in FIG.2A; and FIG.3B is a graph showing a relationship between an applied voltage and a current density of the channel with respect to the conduction path from the source electrode to the channel of the field-effect transistor shown in FIG.2A;
FIG.4A is a view showing a flow of fabricating a field-effect transistor of the present invention; FIG.4B is a view showing a flow of fabricating a field-effect transistor of the present invention;
FIG.5 is a view showing a complementary theory circuit including a field-effect transistor of the present invention;
FIG.6 is a graph showing a relationship between the gate voltage and the sheet electron density of the channel of a field-effect transistor of the present invention.
FIG.7 is a model view of bilayer graphene.
FIGS.8-1 and 8-2 are a view showing a simulation model of a field-effect transistor of the present invention (FIG.8-1) and a graph showing a relationship between the gate voltage and the drain current when the band gap EG of the graphene layer of the simulation model shown in FIG.8-1 is set to be 0.01 eV and 0.18 eV (FIG.8-2).
FIGS.8-3 and 8-4 are a graph showing an electron density and a hole density when a positive voltage is applied to the gate electrode of the simulation model shown in FIG.8-1 (FIG.8-3) and a graph showing the electron density and the hole density when a negative voltage is applied to the gate electrode of the simulation model shown in FIG.8-1 (FIG.8-4).

### Description of Embodiments

A field-effect transistor of the present invention has a semiconductor substrate, a channel including a graphene layer, source and drain electrodes, and a gate electrode. The field-effect transistor of the present invention may be an n-type field-effect transistor or may be a p-type field-effect transistor. The channel including a graphene layer and the source and drain electrodes are not in direct contact but are connected via a semiconductor layer.

The semiconductor substrate of the field-effect transistor of the present invention is not particularly limited, but is preferably a silicon substrate. This is because, as described later, a graphene layer that will be a channel must be disposed on the semiconductor substrate; and a silicon carbide layer that will be a precursor of the graphene layer can be epitaxially grown on a silicon substrate.

Further, the semiconductor substrate in the n-type field-effect transistor may be a p-type silicon substrate; and the semiconductor substrate in the p-type field-effect transistor may be an n-type silicon substrate.

Also, the source region and the drain region of the semiconductor substrate are each doped. In the case of an n-type field-effect transistor, the source region and the drain region of the semiconductor substrate may be doped with n-type; and in the case of a p-type field-effect transistor, the source region and the drain region of the semiconductor substrate may be doped with p-type. Means for doping is not particularly limited and a conventional technique may be used.

The channel of the field-effect transistor of the present invention includes a graphene layer. The graphene layer may be one layer of graphite (monolayer graphene) or a plurality of (for example, two) layers of graphite (multilayer graphene). When a multilayer graphene is provided, a band gap can be allowed to appear by giving a potential difference between the layers of the multilayer graphene. In order to give a potential difference between the layers of the multilayer graphene, a built-in electric field between the silicon substrate and the channel may be applied, or a bias may be applied to the semiconductor substrate.

The source region and the drain region of the graphene layer that will be a channel are each preferably doped. In other words, when an n-type field-effect transistor is to be provided, the source region and the drain region may be doped with n-type; and when a p-type field-effect transistor is to be provided, the source region and the drain region may be doped with p-type.

In order to dope graphene with n-type, ammonia may be adsorbed, for example; and on the other hand, in order to dope graphene with p-type, water or nitrogen dioxide may be adsorbed, for example (T. O. Wehling et al., "Molecular doping of graphene," Nano Lett., vol. 8, pp. 173-177, 2008). Also, a possibility of electric charge transfer from n-type or p-type GaAs to graphene is known (T. A. G. Eberlein et al., "Doping of graphene; density functional calculations of charge transfer between GaAs and carbon nanostructures," Phys. Rev. B, vol.78, p. 045403, 2008). Further, transfer of electrons to graphene formed on n-type SiC is suggested (T. Ohta et al., "Interlayer interaction and electronic screening in multilayer graphene investigated with angle-resolved photoemission spectroscopy," Phys. Rev. Lett., vol. 98, p. 206802, 2007).

A channel including a graphene layer can be obtained by graphenizing the surface of a layer made of a graphene precursor. An example of the layer made of a graphene precursor is a silicon carbide layer or the like. For graphenizing the surface of a silicon carbide layer, a technique shown in the following document can be used, for example. Namely, graphenization can be made by annealing the silicon end surface of 6H-SiC at 1250°C to 1450°C (C. Berger et al., "Ultrathin epitaxial graphite: 2D electron gas properties and a route toward graphene-based nanoelectronics," J. Chem. B, vol. 108, pp. 19912-19916, 2004.).

Of course, graphenization of silicon carbide is not limited to this, and graphenization can be made by carbonizing the surface of 3C-SiC epitaxially grown on a silicon substrate.

The channel of the field-effect transistor of the present invention may be a graphene layer obtained by thermal decomposition of the surface of a silicon carbide layer disposed on the surface of a semiconductor substrate; however, a part of silicon carbide may remain without being graphenized. The thickness of the remaining silicon carbide layer may be a thickness of a degree enabling a tunnel conduction, and specifically, is preferably 5 to 100 nm. It seems that, the smaller the thickness of the remaining silicon carbide layer is, the easier the control of the channel conduction by the gate electrode will be.

Also, the source region and the drain region of the silicon carbide layer remaining without being graphenized are each doped. In the case where the transistor is an n-type field-effect transistor, it is doped with n-type; and in the case where the transistor is a p-type field-effect transistor, it is doped with p-type. The doping of the silicon carbide layer can be carried out in the same manner as in a conventional technique.

The source electrode and the drain electrode of the field-effect transistor are made of a metal material. Examples of the metal material include platinum and others; however, it is not particularly limited. The field-effect transistor of the present invention is **characterized in that** the channel including the graphene layer and the source and drain electrodes made of a metal are not in direct contact but are connected via a semiconductor layer. The semiconductor layer that connects the channel including the graphene layer with the source and drain electrodes can be the source and drain regions of the semiconductor substrate and further can be the source and drain regions of the silicon carbide layer. In other words, the source electrode made of a metal and the channel are preferably connected via the source region of the semiconductor substrate and the source region of the silicon carbide layer. Similarly, the drain electrode made of a metal and the channel are preferably connected via the drain region of the semiconductor substrate and the drain region of the silicon carbide layer.

The gate electrode of the field-effect transistor of the present invention may be disposed so as to be insulated from the channel and to be capable of controlling the electric current flowing through the channel, so that a form of arrangement thereof is not particularly limited. In other words, it may be disposed to the channel via an insulating layer (which is also referred to as a top gate) or may be disposed on the back surface of the semiconductor substrate (the back surface opposite to the surface in which the channel is disposed) (which is also referred to as a bottom gate).

Examples of the gate insulating layer that insulates the gate electrode from the channel include a silicon oxide (SiO₂) layer, an aluminum oxide (Al₂O₃) layer, a hafnium oxide (HfO₂) layer, a zirconium oxide (ZrO₂) layer, and the like. Forming of the gate insulating layer may be carried out, for example, by the deposition method, and is similar to forming a gate insulating layer in a typical MOSFET.

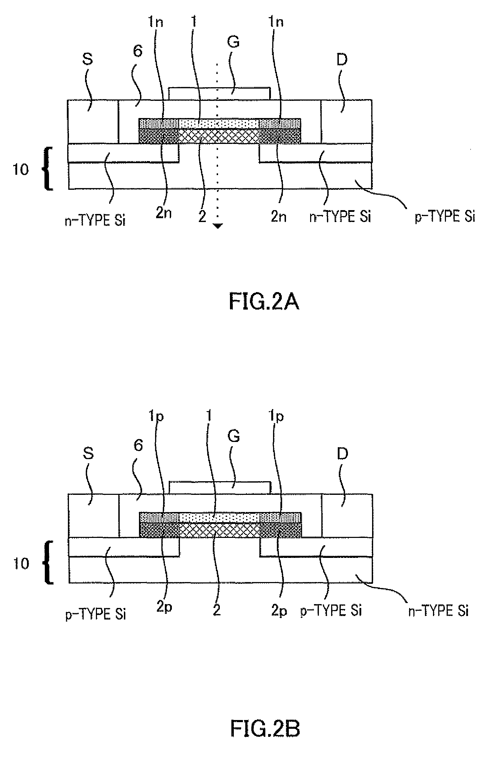

FIG.2A shows a schematic cross-sectional view of an n-type graphene field-effect transistor of the present invention. The field-effect transistor shown in FIG.2A has silicon substrate 10, graphene layer 1, silicon carbide layer 2, gate insulating layer 6, source electrode S, drain electrode D, and gate electrode G. Silicon substrate 10 is a silicon substrate in which the source region and the drain region of a p-type silicon substrate are made to be of n-type. Source and drain regions In of graphene layer 1 and source and drain regions 2n of silicon carbide layer 2 are also made to be of n-type.

FIG.2B shows a schematic cross-sectional view of a p-type graphene field-effect transistor of the present invention. The field-effect transistor shown in FIG.2B also has silicon substrate 10, graphene layer 1, silicon carbide layer 2, gate insulating layer 6, source electrode S, drain electrode D, and gate electrode G. Silicon substrate 10 is a silicon substrate in which the source region and the drain region of an n-type silicon substrate are made to be of p-type. Source and drain regions 1p of graphene layer 1 and source and drain regions 2p of silicon carbide layer 2 are also made to be of p-type.

The field-effect transistor of the present invention is characterized by not having ambipolar properties despite being a graphene channel with no band gap or with an extremely small band gap.

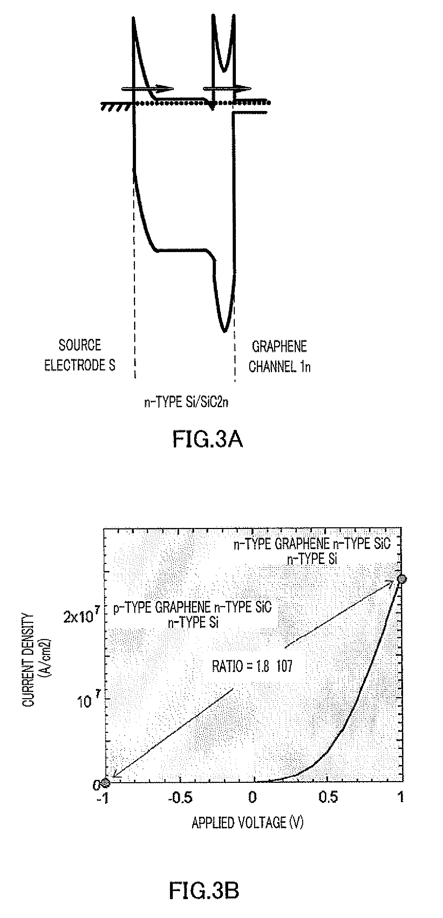

FIG.3A shows a potential distribution along a conduction path from source electrode S to source region 1n of graphene layer 1 in the field-effect transistor (n-type) shown in FIG.2A. Also, though not illustrated in the drawings, the potential distribution view along a conduction path from drain electrode D to drain region In of graphene layer 1 is also similar to that of FIG.3A.

It will be understood that electrons can be injected from source electrode S to source region 1n of graphene layer 1 when tunnel conduction is enabled by reducing the thickness of n-type doped silicon carbide layer 2n. Further, since the potential barrier against the holes is high, holes are not injected into the channel when a negative voltage is applied between source electrode S and gate electrode G. In other words, only the electrons contribute to conduction, so that the ambipolar properties are not exhibited.

FIG.3B shows a result of simulating a relationship between the channel current density and the applied voltage, by using Poisson equation and current continuity equation, for a system along a conduction path from source electrode S to source region In of graphene layer 1 shown in FIG.2A. The thickness of the silicon carbide layer was set to be 5 nm; and the impurity concentration of the graphene layer, the silicon carbide layer and the silicon was set to be 10²⁰ cm⁻³. As shown in FIG.3B, when the applied voltage is positive, electric current flows through n-type graphene - n-type SiC - n-type Si (See the positive bias region of FIG.3B). On the other hand, when the applied voltage is negative, little electric current flows even when the graphene layer is inverted to be of p-type (See the negative bias region of FIG.3B). The current density when the applied voltage is +1 V is 1 × 10⁷ or more times as large as the current density when the applied voltage is -1 V.

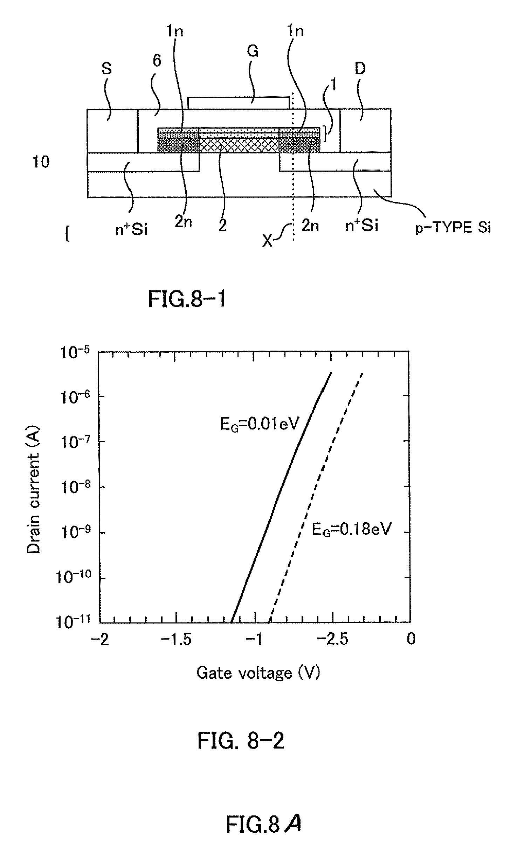

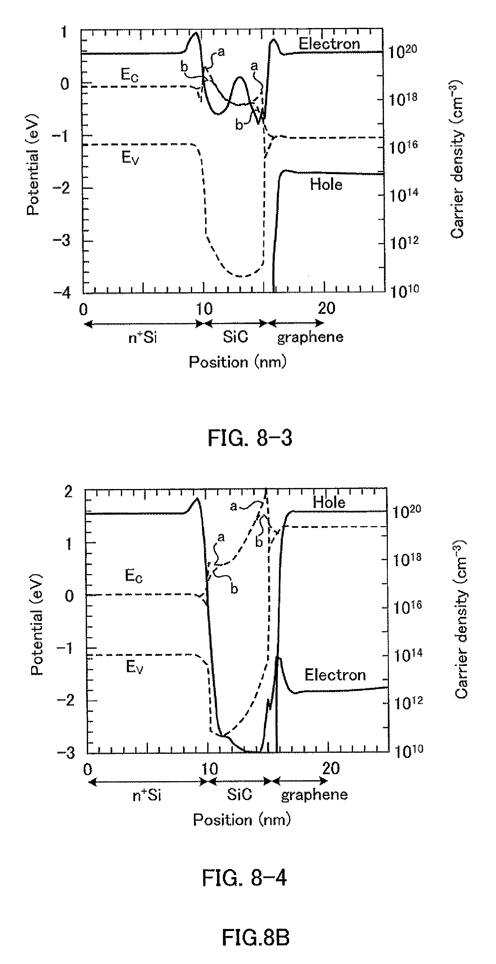

Results of determining a relationship between the gate voltage and the drain current (FIG.8-2), and the carrier distribution and the potential distribution (FIGS.8-3 and 8-4) by simulating a model of the field-effect transistor shown in FIG.8-1 are shown.

First, the model shown in FIG.8-1 is similar to the n-type field-effect transistor shown in FIG.2A; however, a potential difference was provided by allowing graphene layer 1 to have a bilayer structure. In order to provide a potential difference between the layers, each layer of the graphene layer may be separately doped.

Simulation has been made in the case in which the band gap EG as a whole of graphene layer 1 having a bilayer structure is set to be 0.01 eV and in the case in which it is set to be 0.18 eV. For each case, the source-drain voltage has been set to be 50 mV, and the drain current that flows through graphene layer 1 having a bilayer structure has been determined when the gate voltage is scanned from -2 up to 0 V. FIG.8-2 shows in solid line the case in which the band gap EG is set to be 0.01 eV and shows in dotted line the case in which the band gap EG is set to be 0.18 eV.

FIGS.8-3 and 8-4 show a relationship between position in the channel layer (X-axis) to the electric potential (left side of Y-axis) and the carrier density (right side of Y-axis) when the band gap EG as a whole of graphene layer 1 having a bilayer structure is set to be 0.02 eV. 0 in the X-axis means the n⁺Si region in FIG.8-1; 10 nm in the X-axis means the n⁺Si region/SiC (symbol 2n) interface in FIG.8-1; and 15 nm in the X-axis means the SiC (symbol 2n)/graphene (symbol 1n) interface (See the dotted line X in FIG.8-1). For the convenience of calculation, the thickness of graphene layer 1 in the model of the field-effect transistor of FIG.8-1 is set to be excessively large; however, the actual thickness of graphene layer 1 is about 0.68 nm.

Ec (dotted line) in FIGS.8-3 and 8-4 shows a lower end (conduction-band edge) of the energy of the conduction band; and Ev (dotted line) shows an upper end (valence-band edge) of the energy of the valence electron band (See the left side of Y-axis). The gap between Ec and Ev will be the band gap. Among Ec, the curved line a in the SiC region shows a potential when the quantum effect is ignored; and the curved line b shows a potential when the quantum effect is considered.

On the other hand, Electron (solid line) in FIGS.8-3 and 8-4 shows the electron density; and Hole (solid line) shows the hole density (See the right side of Y-axis).

FIG.8-3 shows a case in which a positive voltage is applied to the gate electrode of FIG.8-1; and FIG.8-4 shows a case in which a negative voltage is applied to the gate electrode. As shown in FIG.8-3, it will be understood that, when a positive voltage is applied to the gate electrode, electrons are induced and an electric current flows. On the other hand, as shown in FIG.8-4, when a negative voltage is applied to the gate electrode, holes are not injected though the holes are induced. In this manner, it will be understood that the field-effect transistor of the present invention does not exhibit the ambipolar properties.

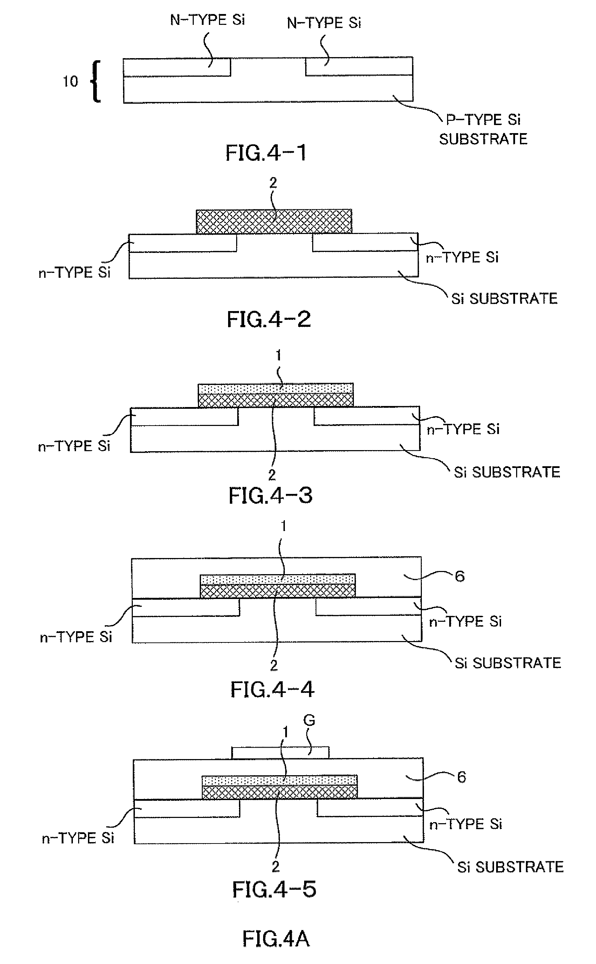

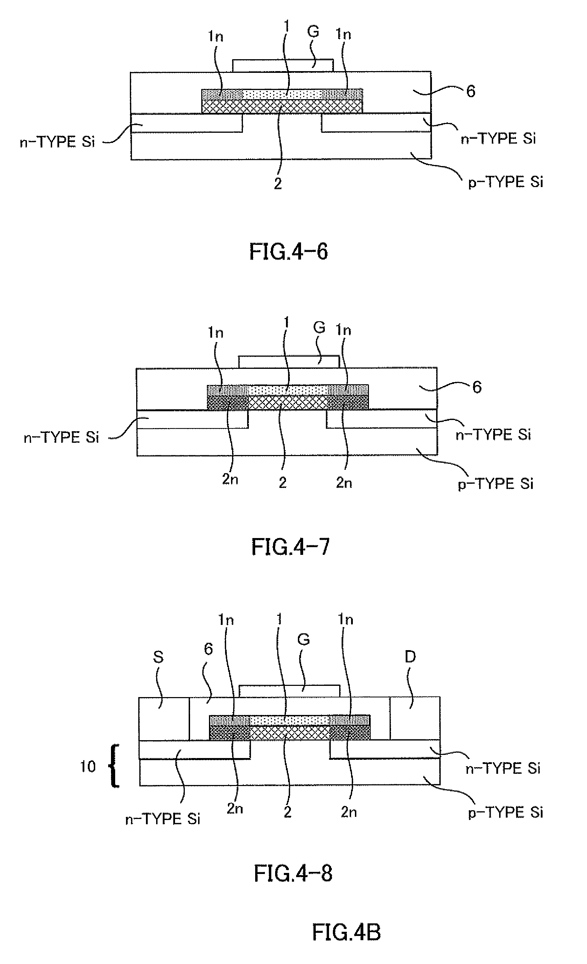

A method of producing the field-effect transistor of the present invention is not particularly limited; however, one example thereof will be described below. FIGS.4A and 4B show a summary of the process flow of fabricating an n-type transistor (See FIG.2A) among the field-effect transistors of the present invention.

First, p-type silicon substrate 10 is prepared, and a part thereof (the part that will be the source and drain regions) is doped with n-type (FIG.4-1). The doping may be carried out by using the ion implantation method or the like.

Silicon carbide layer 2 is disposed on the silicon substrate so as to cross over the doped region (FIG.4-2). Silicon carbide layer 2 on the substrate is preferably formed by epitaxial growing.

A surface layer of silicon carbide layer 2 is graphenized to form graphene layer 1 (FIG.4-3). The graphenization is carried out, for example, by thermal decomposition of the 6H-Si surface of silicon carbide layer 2 at 1200°C to 1700°C. By thermal decomposition, the Si atoms in the surface of silicon carbide layer 2 are removed, and the C atoms are condensed to form graphene layer 1.

Insulating film 6 is formed on the substrate to cover graphene layer 1 (FIG.4-4). Insulating film 6 can be a silicon oxide (SiO₂) layer, an aluminum oxide (Al₂O₃) layer, a hafnium oxide (HfO₂) layer, a zirconium oxide (ZrO₂) layer, or the like. Insulating film 6 functions as a gate insulating layer.

Gate electrode G is disposed on insulating film 6 (FIG.4-5).

The source and drain regions of graphene layer 1 are doped with n-type to form a doped region In (FIG.4-6). The doping of graphene layer 1 may be carried out as described previously.

Also, the source and drain regions of silicon carbide layer 2 are doped with n-type to form n-type doped region 2n (FIG.4-7). For n-type doping of silicon carbide, part of the constituent elements may be substituted with nitrogen, phosphorus, arsenic, antimony, or the like by the ion implantation method.

Next, source electrode S and drain electrode D are formed (FIG.4-8). In other words, insulating film 6 may be etched to expose the n-type doped regions (source region and drain region) of the silicon substrate, and a metal may be vapor-deposited. By this, an n-type graphene field-effect transistor is obtained.

A p-type graphene field-effect transistor can be fabricated in the same manner as in the flow of fabricating the n-type graphene field-effect transistor shown in FIGS.4A to 4B. In other words, a p-type graphene field-effect transistor is obtained in the same manner except for doping an n-type silicon substrate with p-type instead of doping a p-type silicon substrate with n-type (See FIG.4-1); further doping the source and drain regions of graphene layer 1 with p-type instead of doping with n-type (See FIG.4-6); and doping the source and drain regions of silicon carbide layer 2 with p-type instead of doping with n-type (See FIG.4-7).

In this manner, the field-effect transistor of the present invention has a structure similar to that of a typical MOS transistor, and also can be made to be of either p-type or n-type by doping in the same manner as in a method of producing a typical MOS transistor. In other words, a circuit can be formed by using a current MOS circuit as it is.

As described above, the field-effect transistor of the present invention is characterized by not having ambipolar properties though having a graphene channel. Therefore, it can be suitably used as a transistor constituting a complementary logic circuit. A complementary logic circuit refers to a circuit obtained by combination of an n-type transistor and a p-type transistor, and has advantages such as enabling high integration by miniaturization; having low electric power consumption; enabling operation at a low voltage; and having a large noise margin. An n-type transistor and a p-type transistor of a complementary logic circuit can be made to be the field-effect transistors of the present invention.

In a complementary logic circuit, an n-type transistor and a p-type transistor must be formed on one and the same semiconductor substrate, and each transistor is formed generally in a diffusion region referred to as a well. There are various kinds of well structures; however, a complementary logic circuit of the present invention can be applied to any of the well structures.

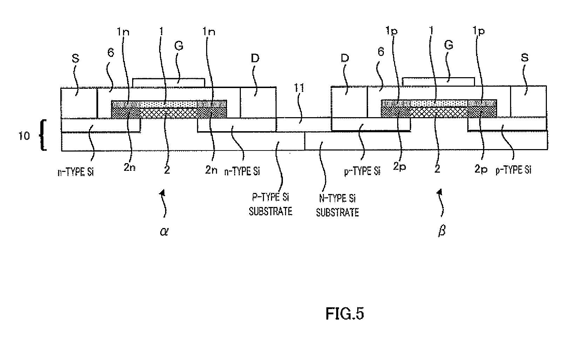

FIG.5 shows an example of a complementary logic circuit including the field-effect transistors of the present invention. It includes two field-effect transistors of the present invention, where one is an n-type graphene field-effect transistor α; and the other is a p-type graphene field-effect transistor β. The field-effect transistor α and the field-effect transistor β are subjected to element separation from each other by field oxide film 11. Of course, means for element separation is not particularly limited. The other symbols in FIG.5 are the same as those in FIGS.2A and 2B.

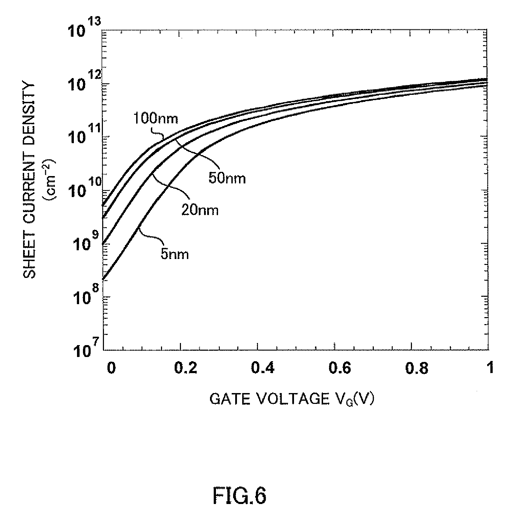

FIG.6 is a graph showing a result of simulating a relationship between the gate voltage (lateral axis) and the sheet electron density (longitudinal axis) of the graphene channel of the field-effect transistor of the present invention shown in FIG.2A. With respect to a one-dimensional system of a gate, an insulating film, graphene, silicon carbide, and a silicon substrate (See the dotted line in FIG.2A), calculation was carried out by using Poisson equation and current continuity equation. The acceptor concentration at which graphene, silicon carbide, and silicon were doped was set to be 10¹⁸ cm⁻³. The gate insulating layer was made of hafnium oxide (HfO₂), and the thickness was set to be 5 nm. Then, curves are shown when the thickness of the silicon carbide layer is set to be 100 nm, 50 nm, 20 nm, and 5 nm.

As shown in FIG.6, it will be understood that the sheet electron density of the channel is controlled by the gate voltage. In other words, the On/Off ratio can be adjusted to be 10² to 10⁴. Also, when the gate voltage is 0 (at the off time), the sheet electron density of the channel is low, and the electric current that flows through the channel is little, which is convenient. Also, it will be understood that, the smaller the thickness of the silicon carbide layer is, the easier it will be to control the sheet electron density of the channel by the gate voltage.

### Industrial Applicability

By the present invention, a graphene field-effect transistor is provided that realizes super low electric power consumption and super large-scale integration that a conventional CMOS circuit has while enjoying the super high-speed properties that a graphene material has. The present invention is a technique that enables providing a field-effect transistor having a graphene channel for the first time by a practical technique excellent in mass productivity. It will be a breakthrough that solves the technique saturation that the current semiconductor technique road map faces.

### Reference Signs List

1 graphene layer
1n n-type doped source and drain regions of the graphene layer
1p p-type doped source and drain regions of the graphene layer
2 silicon carbide layer
2n n-type doped source and drain regions of the silicon carbide layer
2p p-type doped source and drain regions of the silicon carbide layer
5 silicon carbide substrate
6 gate insulating layer
10 silicon substrate
11 field oxide film
S source electrode
D drain electrode
G gate electrode

## Claims

1. A field-effect transistor having a semiconductor substrate, a channel including a graphene layer disposed on said semiconductor substrate, a source electrode and a drain electrode comprising a metal, and a gate electrode, wherein
said channel and said source and drain electrodes comprising a metal are connected via a semiconductor layer.

2. The field-effect transistor according to claim 1, wherein said semiconductor layer is a source region and a drain region of said semiconductor substrate.

3. The field-effect transistor according to claim 1, wherein
said graphene layer is formed on a layer comprising a graphene precursor disposed on said semiconductor substrate,
and
said channel and said source and drain electrodes comprising a metal are connected via said semiconductor layer and said layer comprising a graphene precursor.

4. The field-effect transistor according to claim 1, wherein
said graphene layer is formed on a silicon carbide layer disposed on said semiconductor substrate, and
said channel and said source and drain electrodes comprising a metal are connected via said semiconductor layer and said silicon carbide layer.

5. The field-effect transistor according to claim 4, wherein said silicon carbide layer has a thickness of 100 nm or less.

6. The field-effect transistor according to claim 1, which is an n-type field-effect transistor wherein
a source region and a drain region of said graphene layer are n-type doped, and
the semiconductor layer that connects said channel and said source and drain electrodes comprising a metal is n-type doped.

7. The field-effect transistor according to claim 1, which is a p-type field-effect transistor wherein
a source region and a drain region of said graphene layer are p-type doped, and
the semiconductor layer that connects said channel and said source and drain electrodes comprising a metal is p-type doped.

8. The field-effect transistor according to claim 1, wherein
said graphene layer is a graphene layer including two or more layers, and
a potential difference can be given between the layers of said graphene layer.

9. The field-effect transistor according to claim 8, wherein said graphene layer is made of two layers.

10. The field-effect transistor according to claim 8, wherein the potential difference is given between the layers of said graphene layer by applying a built-in electric field between said semiconductor substrate and the channel or by applying a bias to the semiconductor substrate.

11. A complementary logic circuit comprising a field effect transistor according to claim 6 and a field effect transistor according to claim 7.
